# EUROPEAN PATENT APPLICATION

(11) **EP 4 284 130 A1**
(43) Date of publication of application: **29.11.2023**
(21) Application number: 22174770.2
(22) Date of filing: 23.05.2022
(51) Int. Cl.: H05K 7/14, G05B 19/00

(54) **AN INLAY ELEMENT, A MODULE TERMINATION UNIT, AN INPUT/OUTPUT DEVICE, A MODULAR PROCESS CONTROL SYSTEM AND A METHOD FOR ASSEMBLING AN INPUT/OUTPUT DEVICE**

(71) Applicant: ABB SCHWEIZ AG, 5400 Baden (CH)
(72) Inventor: KEUL, Thomas, 63579 Freigericht (DE); OZER, Can, 724 61 Västerås (SE); EHLENBROEKER, Malte, 32105 Bad Salzuflen (DE); RYDBERG, Martin, 723 43 Västerås (SE); WANG, Sean-Lei, Shanghai 201316 (CN)
(74) Representative: Maiwald GmbH

(57) **Abstract**

Inlay element (10) configured to be arranged in a module termination unit (11) of a modular process control system, wherein the inlay element (10) comprises:
a first connector section (12a) and a second connector section (12b), wherein the first connector section (12a) is configured to be connected to at least one controller module (13) and wherein the second connector section (12b) is configured to be connected to at least one fieldbus device.

## Description

### FIELD OF THE INVENTION

The present invention relates to an inlay element configured to be arranged in a module termination unit, a module termination unit, an input/output device, a modular process control system and a method for assembling an input/output device.

### BACKGROUND OF THE INVENTION

Process control systems are generally known in the prior art. Process control systems comprise several different hardware units, for example, at least one I/O module with several signal conditioning units, a power source, a communication interface unit, a module terminal unit and a control unit. Process control systems are used among others to control complex production plants, e.g. in process industry or automobile industry. For example, such a system was developed by the applicant under the type designation ABB Ability System 800xA Select I/O. In practice, a process control system comprises several different field devices, which are connected with the I/O modules on the module termination unit.

It has now become apparent, due to the wide range of applications, that there is a need to provide further means to improve the modularity of process control systems.

In view of the above, it is an object of the present invention to provide further means to improve the modularity of process control systems. It is in particular an object of the invention to provide an inlay element which allows a flexible configurations of a module termination unit.

These and other objects, which become apparent upon reading the following description, are solved by the subject matter of the independent claims. The dependent claims refer to preferred embodiments of the invention.

### SUMMARY OF THE INVENTION

According to a first aspect of the present disclosure, an inlay element is provided comprising:
a first connector section and a second connector section, wherein the first connector section is configured to be connected to at least one controller module and wherein the second connector section is configured to be connected to at least one fieldbus device and/or a control network.

The term controller module is to be understood broadly. That means a controller module may be for example a module for controlling input/output units or a fieldbus communication interface.

The inlay element is a separate component from the module termination unit. As such, the inlay element may be distributed separately.

In an assembled state, the inlay element is removable connected to the module termination unit. This means, the inlay element may be replaced in case of an error or malfunction.

The first connector section comprises at least one connection means for an controller module. The second connector section comprises at least one connection means for a field bus device and/or a control network. There may be different possible configurations of the first connector section and second connector section. In other words the first and second connector sections may be customized for a specific input/output device or fieldbus device.

In an embodiment, the first connector section comprises at least one connection interface for at least one controller module, for example a module fieldbus interface. In this way, the inlay element may be connected to controller module, e.g. a module fieldbus.

In an embodiment, the second connector section comprises at least one type of fieldbus connection interface for a fieldbus device. In this way, the inlay element may be connected to a fieldbus device.

In an embodiment, the fieldbus connection interface of the second connector section comprises one or more RJ45 sockets and/or D-SUB sockets and/or USB sockets.

Therefore, many different types of connections for the first and second connector sections may be provided. However, other types of connections are possible.

In an embodiment, the inlay element is configured to be connected to the module termination unit by form fitting, in particular by a latching mechanism. Form fitting, in particular latching, provides an easy way to arranging the inlay element removably in the module termination unit. Other connection means, for example screws, may also be possible.

In an embodiment, the inlay element my comprise a mechanical coding. For example, the inlay element may comprise tongues or protrusions which interact with corresponding receptacles and notches. This feature may prevent the insertion of a wrong inlay element into the wrong position in a module termination unit.

A further aspect of the present disclosure comprises a module termination unit comprising at least one connection port for housing at least one controller module and a recess, wherein the recess is configured to hold/house an inlay element, in particular an inlay element according to one of the above mentioned embodiments.

The module termination unit may be preferably a compact module termination unit. A compact module termination unit is a single module termination unit which can hold a certain number of controller modules. Module termination units may be designed to hold or several controller modules.

The recess and the inlay element correspond to each other. In particular the geometries of the recess and the inlay element correspond to each other. The recess may be configured to hold the inlay element by form fitting, for example by a latching mechanism. Other connection means are possible.

In an embodiment, the module termination unit is configured to have no direct signal connection and/or electrical connection to the inlay element. In this way, the connection ports of the module termination unit may be hard wired on one common printed circuit board assembly (PCBA) and may forward high speed communication signals and/or low speed or DC signals like slot identification-signals and power-signals.

In an embodiment, in an assembled state, the controller module is connected to the module termination unit via the connection port and to the inlay element via the connection interface. This provides a way to further modularize the module termination unit. As a result, it is possible to easily replace controller modules and it is also possible to replace the fieldbus connection interface without replacing the whole module termination unit.

In an embodiment, the connection ports are hard wired on a common circuit board of the module termination unit. This allows communication between the controller modules and/or fieldbus communication interface modules. The complex horizontal wiring allows bus and peer to peer communication between controllers and fieldbus communication interfaces.

In an embodiment, in an assembled state, the controller module arranged on the module termination unit is connected to a field device via the fieldbus connection interface of the inlay element. Alternatively, the controller module may be connected to a controller network.

A further aspect of the present disclosure relates to an input/output device comprising a module termination unit according to one of the above embodiments housing at least one controller module and an inlay element according to one of the above embodiments.

A further aspect of the present disclosure relates to a modular process control system comprising at least one input/output device as mentioned above, which is connected to one or more field devices.

A further aspect of the present disclosure relates to a method for assembling an input/output device according to the above embodiment comprising the following steps:
providing a module termination unit according to any of the preceding embodiments;
arranging an inlay element according to any of the above embodiments inside the recess of the module termination unit;
connecting an controller module with the module termination unit and the inlay element by inserting the controller module into the respected sockets.

The respected sockets refer to the connections ports of the module termination unit and the field connection interface of the inlay element.

### BRIEF DESCRIPTION OF THE DRAWINGS

The accompanying drawings, which are included to provide a further understanding of the invention and are incorporated in and constitute a part of this application, illustrate embodiments of the invention and together with the description serve to explain the principle of the invention. The drawings display:
- **Figure 1**: a perspective view of a schematic drawing of a module termination unit with controller modules and inlay elements;
- **Figure 2**: a top view of a schematic drawing of a module termination unit with controller modules and inlay elements; and
- **Figure 3**: a top view of a module termination unit.

### DESCRIPTION OF THE EMBODIMENTS

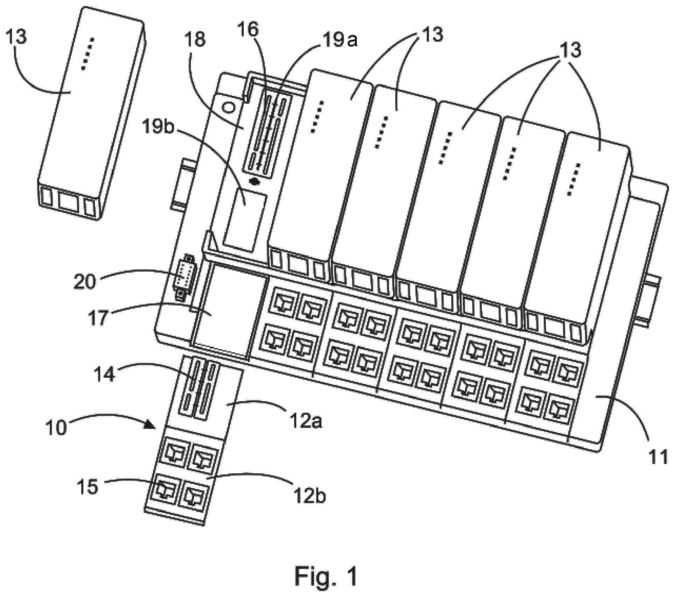

Fig. 1 shows a schematic drawing of a module termination unit 11. The module termination unit 11 has a rectangular geometry with longitudinal and transverse sides. Other forms may be possible.

The module termination unit 11 may comprises six connection ports 16. The connection ports 16 may have two adjacent connection slots as exemplary shown in Fig. 1. In alternative embodiments, a different number of connection ports 16 and connection slots and also a different arrangement may be present.

The module termination unit 11 further comprises a recess 17. The geometry of the recess 17 in configured to house a total of six inlay elements 10. Alternatively, the recess 17 may be configured to house a different number of inlay elements 10. Therefore, for each inlay element 10 one recess 17 may be provided. In other words, embodiments with multiple recesses 17 for one or more inlay elements 10 are possible.

In Fig. 1, five inlay elements 10 are housed in the recess 17. A sixth inlay element 10 is arranged beside the module termination unit 11. The sixth inlay element 10, on the bottom left, is in a state right before it is arranged in the recess 17 of the module termination unit 11. This demonstrates, that the inlay elements 10 are separate components from the module termination unit 11. The inlay elements 10 are arranged removable in the recess 17. All six inlay elements 10 shown in Fig. 1 are identical to each other.

The inlay element 10 is provided by a plate with a rectangular form. Other forms are possible. The inlay element 10 comprises a first connector section 12a and a second connector section 12b. The first connector section 12a and the second connector section 12b each take up a part of the inlay element 10, in particular in longitudinal direction. The first connector section 12a of the inlay element 10 comprises an connection interface 14. The second connector section 12b of the inlay element 10 comprises a fieldbus connection interface 15. Here, all inlay elements 10 comprise RJ45 sockets as fieldbus connection interfaces 15. Different fieldbus connection interfaces may be provided.

In the embodiment according to Fig. 1, the module termination unit 11 comprises a plate element 18. The plate element 18 is arranged on the module termination unit 11, e.g. by screws. The plate element 18 overlaps with the connection ports 16 of the module termination unit 11. The plate element 18 has first cut-outs 19a. The first cut-outs 19a correspond with the connection ports 16 of the module termination unit 11. In other words, in an assembled state, the connection ports 16 are arranged in and/or under the respective first cut-outs 19a.

The plate element 18 further comprises second cut-outs 19b. The second cut-outs 19b correspond with the connection interfaces 14 of the inlay elements 10. In other words, in an assembled state, the connection interfaces 14 of the inlay elements 10 are arranged in and/or under the second cut-outs 19b.

The inlay elements 10 are configured to slide into the recess 17 and under the plate element 18 until its input/output connection interfaces 14 are arranged in and/or under the respective second cut-out 19b. The inlay element 10 may be connected to the module termination unit 11 by form fitting, e.g. a latching mechanism. As stated above, the inlay element 10 is configured, so it can be removed from the module termination unit 11.

Five controller modules 13 are arranged on the module termination unit 11 via the connection ports 16. One controller module 13 is arranged beside the module termination unit 11 on the far left of Fig. 1. The controller modules 13 are arranged on the plate element 18. The plate element 18 comprises a collar 20, which extends along the longitudinal sides of the plate element 18 and partially along the transverse side of the plate element 18. The transverse side of the plate element 18 is mostly collar free.

In an assembled state, the controller modules 13 are connected to the module termination unit 11 by the respective connection ports 16 and to the inlay elements 10 by the respective connection interfaces 14. In this way, each controller module 13 can be connected to a respective fieldbus device (not shown) by connecting the fieldbus device with the fieldbus connection interface 15 of the respective inlay element 10.

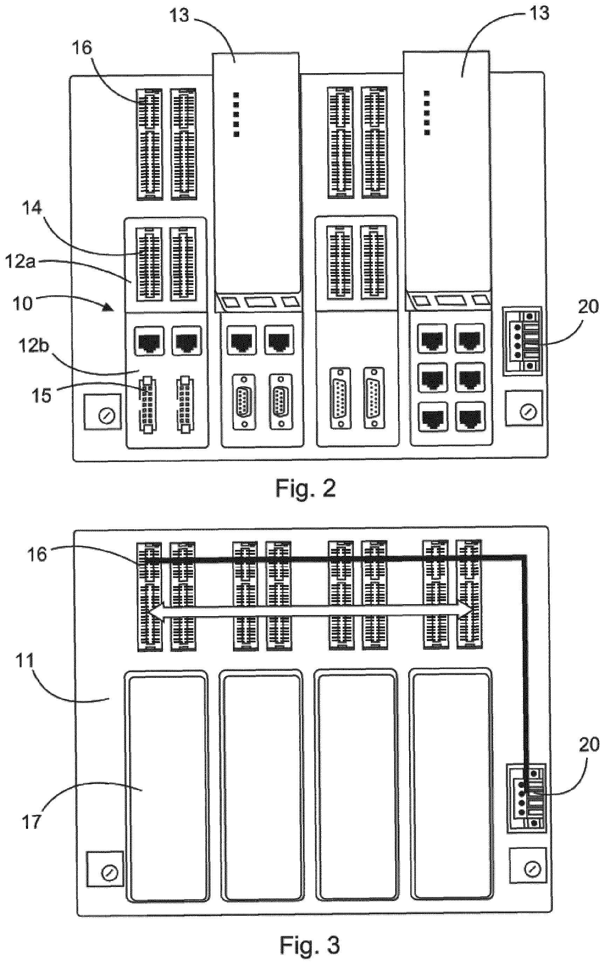

Fig. 2 and Fig. 3 show another embodiment of the present disclosure. Fig. 2 and Fig. 3 both show the same module termination unit 11. Fig. 2 shows an example of the module termination unit 11 with installed inlay elements 10 and controller modules 13. In Fig. 3, the module termination unit 11 is shown without any installed components.

The module termination unit 11 in Fig. 2 comprises four connection ports 16 and four respective recesses 17. Each inlay element 10 is assigned to a respective recess 17.

The recesses 17 have a rectangular shape. The shape of the recesses 17 corresponds to the shape of the inlay elements 10.

The inlay elements 10 are arranged in all four recesses 17. The inlay elements 10 in this embodiment differ from each other. More precisely, the second connector section 12b of each inlay element 10 comprises a different configuration. Here, the first inlay element 10 on the first position comprises RJ45 and USB sockets, the inlay elements 10 on the second and third position comprises RJ45 and D-SUB sockets and the inlay element 10 on the fourth position only comprises RJ45 sockets. The positions refer to the arrangement of the inlay elements 10 from left to right according to Fig. 2.

Two controller modules 13 are arranged on the module termination unit 11. An controller module 13 is arranged on the second position of the module termination unit 11 and a another controller module 13 is arranged on the fourth position of the module termination unit 11. The positions refer to the arrangement of the controller modules 13 from left to right according to Fig. 2. The controller modules 13 are connected with the module termination unit 11 by the connection ports 16 and by the connection interface 14 of the inlay elements 10.

In Fig. 3 the controller modules 13 and the inlay elements 10 are removed. Fig. 3 shows a line and an arrow. The line shows the connection of a power supply 20, which is arranged on the right side of the module termination unit 11, to the connector ports 16. The arrow shows the horizontal connection between the connection ports 16. In other words, the connection ports 16 are hard wired on a common circuit board of the module termination unit 11. This wiring provides high speed signals and larger number of signals between controller modules 13.

In the prior art, a single-wire point-to-point communication between single channel modules and generic input/output modules is possible. The module termination unit 11 with inlay elements 10 according to the present disclosure has a complex horizontal wiring, which allows bus and peer to peer communication between controller modules 13 and/or fieldbus communication interface modules and the field connection interfaces 15.

The inlay elements 10 further provide the possibility to individually configure the system. Meaning, the same type of module termination unit 11 may be used for multiple systems with different specifications. The module termination unit 10 may be customized by installing the respective inlay elements 10.

The inlay elements 10 according to the present disclosure are not signal connected or electrically connected to the module termination unit 11. This means, the inlay elements 10 form a bridge between the controller modules 13 and the connected fieldbus devices and/or a control network.

In summary, the present disclosure provides a flexible user configurable process controller system. The inlay elements 10 allow a lower number of variants for the module termination units 11.

A further advantage provided by the present disclosure is selective repair of the process control system, i.e. of the module termination unit 11. This means, that in case, that a user accessible field interface connector is damaged, only the respective inlay element 10 must be replaced. For this, the controller module 13 on the interface related to the respective inlay element 10 may also have to be removed. The remaining controller modules 13 and other modules on same module termination unit 11 can still operate without impact and can remain.

Any disclosure and embodiments described herein relate to the inlay element, the module termination unit, the input/output device, the modular process control system and the method, lined out above or below and vice versa. The benefits provided by any of the embodiments and examples equally apply to all other embodiments and examples and vice versa.

It shall be noted that all embodiments of the present disclosure concerning the method might be carried out with the order of the steps as described, nevertheless this has not to be the only and essential order of the steps of the method. The herein presented methods can be carried out with another order of the disclosed steps without departing from the respective method, unless explicitly mentioned to the contrary hereinafter.

Other variations to the disclosed embodiments can be understood and effected by those skilled in the art in practicing the claimed invention, from the study of the drawings, the disclosure, and the appended claims. In the claims, the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. Any reference signs in the claims should not be construed as limiting the scope of the claims.

### LIST OF REFERENCES

- 10: inlay element
- 11: module termination unit
- 12a: first connector section
- 12b: second connector section
- 13: controller module
- 14: connection interface
- 15: fieldbus connection interface
- 16: connection port
- 17: recess
- 18: plate element
- 19a: first cut-out
- 19b: second cut-out
- 20: power supply

## Claims

1. Inlay element (10) configured to be arranged in a module termination unit (11) of a modular process control system, wherein the inlay element (10) comprises:
a first connector section (12a) and a second connector section (12b), wherein the first connector section (12a) is configured to be connected to at least one controller module (13) and wherein the second connector section (12b) is configured to be connected to at least one fieldbus device and/or to a control network.

2. Inlay element (10) according to claim 1,
**characterized in that**
the first connector section (12a) comprises at least one connection interface (14) for at least one controller module (13), in particular a module fieldbus interface.

3. Inlay element (10) according to claims 1 or 2,
**characterized in that**
the second connector section (12b) comprises at least one type of fieldbus connection interface (15) for a fieldbus device.

4. Inlay element (10) according to claim 3,
**characterized in that**
the fieldbus connection interface (15) of the second connector section (12b) comprises one or more RJ45 sockets and/or D-SUB sockets and/or USB sockets.

5. Inlay element (10) according to any of the preceding claims,
**characterized in that**
the inlay element (10) is configured to be connected to the module termination unit (11) by form fitting, in particular by a latching mechanism.

6. Module termination unit (11) comprising at least one connection port (16) for housing at least one input/output unit (13); and a recess (17), wherein the recess (17) is configured to hold an inlay element (10), in particular an inlay element according to claims 1 to 5.

7. Module termination unit (11) according to claim 6,
**characterized in that**
the module termination unit (11) has no direct signal connection and/or electrical connection to the inlay element (10).

8. Module termination unit according to claims 6 or 7,
**characterized in that**
in an assembled state, the controller module (13) is connected to the module termination unit (11) via the connection port (16) and to the inlay element (10) via the connection interface (14).

9. Module termination unit (11) according to claims 6 to 8,
**characterized in that**
the connection ports (16) are hard wired on a common circuit board of the module termination unit (11).

10. Module termination unit (11) according to claims 6 to 9,
**characterized in that**
in an assembled state, the controller module (13) arranged on the module termination unit (11) is connected to a field device via the fieldbus connection interface (15) of the inlay element (10).

11. An input/output device comprising a module termination unit (11) according to the claims 6 to 10 housing at least one controller module (13) and an inlay element (10) according to claims 1 to 5.

12. A modular process control system comprising at least one input/output device according to claim 11 connected to one or more field devices.

13. Method for assembling an input/output device according to claim 11 comprising the following steps:
providing a module termination unit (11) according to any one of the claims 6 to 10;
arranging an inlay element (10) according to any of the claims 1 to 5 inside the recess (17) of the module termination unit (11);
connecting an controller module (13) with the module termination unit (11) and the inlay element (10) by inserting controller module (13) into the respective sockets.
